# EUROPÄISCHE PATENTANMELDUNG

(11) **EP 4 130 770 A1**
(43) Veröffentlichungstag der Anmeldung: **08.02.2023**
(21) Anmeldenummer: 21190190.5
(22) Anmeldetag: 06.08.2021
(51) Int. Cl.: G01R 31/392, B60L 58/16

(54) **NUTZUNGSABHÄNGIGE ALTERUNG EINER BATTERIE**

(71) Anmelder: Siemens Aktiengesellschaft, 80333 München (DE)
(72) Erfinder: Schulte, Sascha, 91315 Höchstadt (DE); Arzberger, Arno, 96135 Stegaurach (DE); Baldauf, Manfred, 91056 Erlangen (DE)

(57) **Zusammenfassung**

Die Erfindung betrifft ein Verfahren zur Beurteilung einer Batteriealterung, bei welchem zunächst Anzahlen (Äquivalente Vollzyklen) möglicher Auf- oder Entladevorgänge einer Batterie in Abhängigkeit von der Tiefe (DoD) des jeweiligen Vorgangs ermittelt werden. Dann wird beim Betreiben der Batterie ein zukünftiger Auf- oder Entladevorgang einem Vorgang einer bestimmten Tiefe (DoD) zugeordnet unter Berücksichtigung von einem oder mehreren zuvor erfolgten Auf- oder Entladevorgängen. Schließlich wird ein durch den zukünftigen Auf- oder Entladevorgang hervorgerufener Schädigungswert bestimmt unter Verwendung der ermittelten Anzahl (Äquivalente Vollzyklen) möglicher Auf- oder Entladevorgänge. Weiterhin betrifft die Erfindung hierzu korrespondierend eine Vorrichtung oder ein System zur Datenverarbeitung, ein Computerprogramm, einen computerlesbaren Datenträger, sowie ein Datenträgersignal.

## Beschreibung

Die Erfindung betrifft ein Verfahren zur Beurteilung einer Batteriealterung.

Aufladbare Speichersysteme für elektrische Energie werden für eine Vielzahl von Anwendungen genutzt. Dies wird u.a. verstärkt durch den Trend zur vermehrten Nutzung von erneuerbaren Energieformen und elektrisch betriebenen Fahrzeugen.

Hierbei werden insbesondere Lithium-Ionen-Akkumulatoren aufgrund ihrer hohen Leistungs- und Energiedichte in mobilen und stationären Anwendungen als Energiespeicher eingesetzt. Um diese, aber auch andersartige, elektrische Energiespeicher sicher, zuverlässig und möglichst lang wartungsfrei betreiben zu können, werden insbesondere die beiden Betriebsparamter des Ladezustands (engl.: State of Charge, abgekürzt SoC) und des Alterungs- bzw. Gesundheitszustands (engl: State of Health, abgekürzt SoH), betrachtet.

Es ist bekannt, dass die zyklische oder nutzungsabhängige Alterung einer Batterie, also die durch Lade- und Entladevorgänge hervorgerufene Verschlechterung des Gesundheitszustands der Batterie, abhängig ist vom mittleren Ladezustand während des Lade- und Entladevorgangs und der Entladetiefe. Es ist somit möglich, dass derselbe Typ einer Batterie eine stark unterschiedliche Anzahl von Lastzyklen bewerkstelligen kann, bevor das Lebensdauerende erreicht ist.

Der Erfindung liegt die Aufgabe zugrunde, ein Verfahren zur Beurteilung einer Batteriealterung aufzuzeigen.

Diese Aufgabe wird durch ein Verfahren mit den Merkmalen des Anspruchs 1 gelöst. Ferner sind Gegenstand der Erfindung eine entsprechende Vorrichtung oder ein System zur Datenverarbeitung, ein entsprechendes Computerprogramm, ein entsprechender computerlesbarer Datenträger, und ein entsprechendes Datenträgersignal. Vorteilhafte Ausgestaltungen und Weiterbildungen sind Gegenstand von Unteransprüchen.

Bei dem erfindungsgemäßen Verfahren zur Beurteilung einer Batteriealterung werden in einem ersten Schritt Anzahlen möglicher Auf- oder Entladevorgänge einer Batterie in Abhängigkeit von der Tiefe des jeweiligen Vorgangs ermittelt. Die Tiefe eines Auf- oder Entladevorgangs entspricht hierbei der Änderung des Ladungszustands der Batterie, die durch die Aufladung oder Entladung bewirkt wird; sie kann auch als Hub oder Dod (Depth of Discharge) bezeichnet werden. Als Einheit wird vorzugsweise % gewählt, wobei 100% einer voll aufgeladenen Batterie und 0% einer komplett entladenen Batterie entspricht.

Für mehrere Tiefen wird eine Anzahl möglicher Auf- oder Entladevorgänge bestimmt. In der Regel wird sich diese Anzahl von Tiefe zu Tiefe unterscheiden. Es ist jedoch möglich, dass für manche Tiefen die gleiche Anzahl ermittelt wird. Um zu entscheiden, welche Anzahl an Auf- oder Entladevorgängen möglich ist, wird für alle Tiefen das gleiche Kriterium angewandt. Hierfür eignet sich besonders das Erreichen eines bestimmten Batteriealters. Dieses Batteriealter wird vorzugsweise als SOH (State of Health) angegeben. Es eignet sich z.B. das Erreichen eines SOH von 80% als Kriterium, d.h. es sind so viele Auf- oder Entladevorgänge möglich, bis der SOH auf den Wert 80% gesunken ist. Die Angabe der Anzahl möglicher Auf- oder Entladevorgänge kann z.B. in Zyklen erfolgen, wobei ein Zyklus aus einem Aufladevorgang und einem Entladevorgang der gleichen Tiefe besteht. Vorzugsweise erfolgt die Angabe in äquivalenten Vollzyklen, wobei z.B. vier Zyklen von 25% einem äquivalenten Vollzyklus entspricht.

Die Erfindung kann auf verschiedenartige Batterien angewandt werden. Besonders eignen sich Speichersysteme für elektrische Energie, welche auf der Lithium-Ionen Technologie basieren.

In einem zweiten Schritt wird die Batterie betrieben, d.h. wiederholt aufgeladen und entladen, wobei die Tiefe der verschiedenen Auf- oder Entladevorgänge nicht immer die gleiche ist. Ein bestimmter zukünftiger Auf- oder Entladevorgang wird einem Vorgang einer bestimmten Tiefe zugeordnet unter Berücksichtigung von einem oder mehreren zuvor erfolgten Auf- oder Entladevorgängen. Es wird hierzu in Bezug auf den zukünftigen Auf- oder Entladevorgang also nicht nur betrachtet, um wie viel die Batterie ausgehend von dem aktuellen Ladezustand auf- oder entladen werden soll. Vielmehr werden zusätzlich Informationen über Auf- oder Entladevorgänge betrachtet, welche in der Vergangenheit liegen, um den betrachteten Auf- oder Entladevorgang einem Vorgang einer bestimmten Tiefe zuzuordnen. Dies liegt darin begründet, dass auch unterbrochene Auf- oder Entladevorgänge für eine Batterie sich hinsichtlich ihrer Alterung wie ein einheitlicher Auf- oder Entladevorgang auswirken können.

Die Batterie, welche betrieben wird und für welche die Zuordnung von Auf- oder Entladevorgängen erfolgt, kann das identische Exemplar sein, welches auch für die Ermittlung der möglichen Anzahlen von Auf- oder Entladevorgängen verwendet wurde. Alterativ kann es sich um eine andere Batterie desselben Typs handeln. Es ist jedoch auch möglich, dass eine andersartige Batterie zum Einsatz kommt, von der vermutet wird, dass sie ähnliche Eigenschaften verglichen mit der Batterie des ersten Schrittes hat.

Schließlich wird in einem dritten Schritt ein durch den zukünftigen Auf- oder Entladevorgang hervorgerufener Schädigungswert bestimmt unter Verwendung der ermittelten Anzahlen möglicher Auf- oder Entladevorgänge. Nachdem also die Zuordnung zu einem Vorgang einer bestimmten Tiefe stattgefunden hat, kann unter Verwendung der Ergebnisse des ersten Schrittes die mögliche Anzahl korrespondierend zu dieser Tiefe festgestellt werden. Aus dieser Anzahl kann dann ein Schädigungswert ermittelt werden.

Die Bestimmung des Schädigungswertes erfolgt vorzugsweise, bevor der betrachtete Auf- oder Entladevorgang tatsächlich durchgeführt wird. Auf diese Weise kann er als Entscheidungsgrundlage über die Durchführung des Vorgangs herangezogen werden. Alternativ ist es möglich, den Schädigungswert erst nach Durchführung des Vorgangs zu bestimmen; dies kann z.B. für eine Auswertung der erfolgten Batterienutzung verwendet werden.

Als Einheit für den Schädigungswert kommt unterschiedliches in Betracht. Dies kann daran orientiert sein, zu welchem Zweck der Schädigungswert eingesetzt wird. Für das Ziel einer batterieschonenden Betriebsweise kann er z.B. in äquivalenten Vollzyklen angegeben werden, für eine wirtschaftliche Entscheidung z.B. in Geldeinheiten.

Einer besonders bevorzugten Weiterbildung der Erfindung gemäß erfolgt die Ermittlung der Anzahlen möglicher Auf- oder Entladevorgänge mittels einer Hoch-Präzisions-Coulometrie-Messung. Diese Messungen liegen dem HPC (High Precision Cycling) Verfahren zugrunde, bei welchem eine Batterie wiederholt mit Zyklen einer bestimmten Tiefe belastet wird, um hieraus Aussagen über die durch einen solchen Zyklus hervorgerufene Alterung treffen zu können. Dies kann dadurch funktionieren, dass basierend auf der Hoch-Präzisions-Coulometrie-Messung ein Kapazitätsverlust pro Auf- oder Entladevorgang einer bestimmten Tiefe ermittelt wird. Aus dem Kapazitätsverlust kann auf eine Restkapazität der Batterie und somit auf eine verbleibende Lebenszeit geschlossen werden.

Vorteilhaft ist es, wenn nach einem zeitweiligen Betreiben der Batterie erneut die Ermittlung der Anzahlen möglicher Auf- oder Entladevorgänge erfolgt. Durch Wiederholen des ersten Schrittes nach einer bestimmten Betriebsdauer der Batterie, z.B. nach einem halben Jahr, kann geprüft werden, ob die anfänglich festgestellten Zusammenhänge noch zutreffend sind oder angepasst werden sollten. So würde eine stärker als erwartete Batteriealterung in einer reduzierten Anzahl möglicher Auf- oder Entladevorgänge resultieren.

Es ist möglich, dass die Anzahlen möglicher Auf- oder Entladevorgänge zusätzlich abhängen von dem mittleren Ladezustand der Batterie während des jeweiligen Vorgangs. In diesem Fall besteht also zumindest eine zweifache Abhängigkeit der möglichen Anzahlen: einerseits von der Tiefe des jeweiligen Zustandes, andererseits von dem mittleren Ladezustand. Bei Bedarf können weitere Abhängigkeiten bei der Ermittlung der möglichen Anzahlen einbezogen werden, um auf diese Weise eine noch genauere Prognose über die Alterung der Batterie treffen zu können.

In Weiterbildung der Erfindung wird die Zuordnung eines bestimmten Auf- oder Entladevorgangs zu einem Vorgang einer bestimmten Tiefe wiederholt durchgeführt, und aufgrund von mindestens einem weiteren zwischenzeitlich erfolgten Auf- oder Entladevorgang erfolgt eine neue Zuordnung. Dies bedeutet für einen konkreten Auf- oder Entladevorgang, dass dieser ein erstes Mal als zukünftiger Auf- oder Entladevorgang betrachtet und einem Vorgang einer bestimmten Tiefe zugeordnet wird. Zu einem späteren Zeitpunkt, zu welchem außer dem betrachteten - oder Entladevorgang bereits einer oder mehrere weitere Auf- oder Entladevorgänge stattgefunden haben, wird der konkrete Auf- oder Entladevorgang nun erneut ausgewertet und im Kontext dieser zwischenzeitlich durchgeführten weiteren Auf- oder Entladevorgänge findet erneut eine Zuordnung des konkreten Auf- oder Entladevorgangs statt, welche zu einem anderen Ergebnis führen kann als die erste Zuordnung.

Besonders eignet sich für die Durchführung der Zuordnung der Einsatz eines Rainflow Algorithmus. Ein solcher Algorithmus ermöglicht es, unter Beachtung bestimmter Regeln, welche von der konkreten Art des Rainflow Algorithmus abhängen können, Abschnitte eines Kurvenverlaufs einzuordnen und zu gruppieren.

Vorteilhaft ist es, den Schädigungswert bei einer Entscheidung über die Durchführung eines bestimmten Auf- oder Entladevorgangs zu verwenden. Dies könnte in einem einfach gelagerten Fall z.B. derart realisiert werden, dass ab Überschreiten eines bestimmten Schwellenwertes für den Schädigungswert der jeweilige Auf- oder Entladevorgang nicht durchgeführt wird.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt ablaufen. Besonders eignet es sich, ein erstes Computerprogramm im Rahmen des ersten Schrittes einzusetzen, also für die Ermittlung der möglichen Anzahlen, und ein zweites Computerprogramm für die Zuordnung und Bestimmung des Schädigungswertes. Alternativ ist auch möglich, das gleiche Computerprogramm für die Durchführung der drei Schritte zu verwenden.

Im Folgenden wird die Erfindung anhand eines Ausführungsbeispiels näher erläutert. Dabei zeigen:
Figur 1: den zeitlichen Verlauf des Alterungszustands einer Batterie,
Figur 2: ein Einsatzszenario für eine Batterie,
Figur 3: eine Schadensgewichtungskurve einer Batterie,
Figur 4: eine Schar von Schadensgewichtungskurven einer Batterie,
Figur 5: eine Vorrichtung zum Bestimmen von Schadensgewichtungskurven mittels der Hoch-Präzisions-Coulometrie,
Figur 6: einen Verlauf der Entladung einer Batterie,
Figur 7: einen ersten Verlauf des Ladungszustands einer Batterie zur Illustration des Rainflow Verfahrens,
Figur 8: einen zweiten Verlauf des Ladungszustands einer Batterie zur Illustration des Rainflow Verfahrens.

Es werden auf- und entladbare Speichersysteme für elektrische Energie betrachtet. Hierbei kann es sich um herkömmliche Batteriezellen wie Lithium-Ionen-Akkus, oder auch um Superkondensatoren wie Lithium-Ionen-Kondensatoren handeln. Insbesondere die Lithium-Ionen-Technologie wird aufgrund der hohen durch sie ermöglichten Leistungs- und Energiedichte in mobilen und stationären Anwendungen für Energiespeicher eingesetzt. Im Folgenden wird der Begriff Batterie stellvertretend für diverse Speichersysteme verwendet. Die beschriebene Vorgehensweise ist für einzelne Batterien, wie sie z.B. in elektrischen Fahrzeugen zum Einsatz kommen, ebenso anwendbar wie für große Speicheranlagen, in welche eine Vielzahl von Einzelbatterien integriert sind. Beispiele für letzteres sind Container gefüllt mit Batterien, welche die von einem großen Solarfeld bereitgestellte elektrischen Energie puffern. Ein weiteres verbreitetes Einsatzgebiet von Batterien ist die PRL (Primärregelleistung).

Batterien altern mit jeder Benutzung, wobei die Alterungsursachen vielfältig sein können, z.B. Materialablagerungen an "falschen" Stellen auf einer Elektrode oder Elektrolytaustrocknung. Der Gesundheitszustand einer Batterie wird mit dem SOH, dem "State of Health" angegeben. Jede Benutzung einer Batterie senkt diesen SOH um einen gewissen Betrag. Beispielsweise können handelsübliche Lithium-Ionen-Zellen ca. 1000-4000 mal vollständig ge- und entladen werden, bevor sie keine ausreichende Leistung oder Energie mehr bereitstellen können.

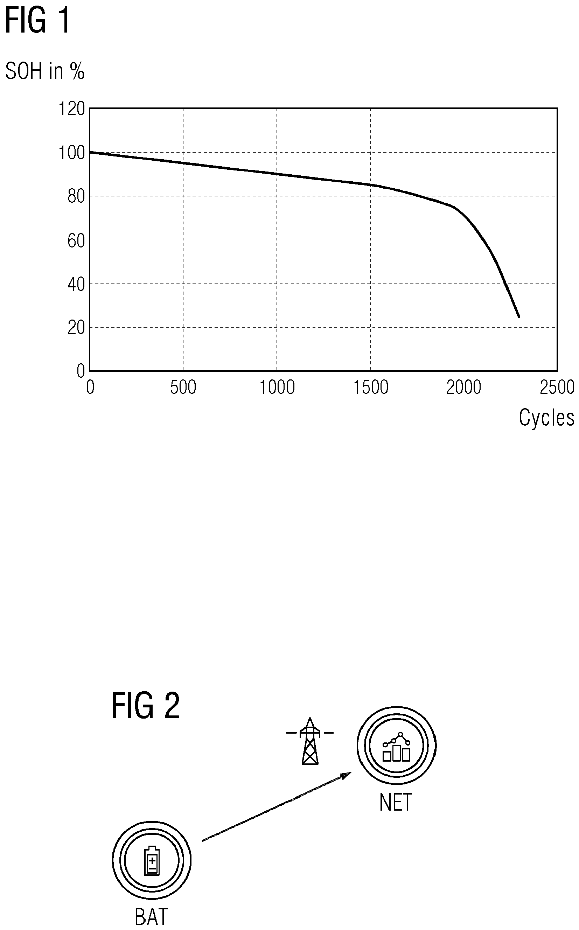

Figur 1 zeigt beispielhaft den Verlauf des Gesundheitszustands einer Batterie SOH, auf der vertikalen Achse aufgetragen, über die Auf- und Entladezyklen Cycles. Es ist zu erkennen, dass jeder Zyklus eine Schädigung der Batterie, entsprechend einer Reduktion des Gesundheitszustands SOH, bewirkt. Der Abfall des Gesundheitszustands SOH ist zunächst in etwa linear, um dann bei ca. 80% rapide abzusinken. Ab dem Zeitpunkt, welcher dem Abknicken des SOH Verlaufs entspricht, sollte die Batterie ausgetauscht werden.

Außer der Alterung der Batterie durch die Nutzung unterliegt die Batterie auch einer zeitabhängigen Alterung; hinter dieser kalendarischen Alterung steht die Beobachtung, dass Batterien auch dann altern, wenn sie gar nicht benutzt, also ge- und entladen werden.

Das Ziel des im Folgenden beschriebenen Verfahrens ist es, eine möglichst lange Dauer der Nutzung einer Batterie mit akzeptablem SOH zu ermöglichen und/oder die Batterie innerhalb des Zeitraums bis zum Erreichen des nicht mehr akzeptablem SOH möglichst effizient zu nutzen.

Es wird die wirtschaftliche Nutzung einer Batterie betrachtet, wie in Figur 2 schematisch dargestellt. Die Batterie BAT speichert elektrische Energie, welche z.B. von einer Solarfarm oder einem Windpark erzeugt wurde. Es findet eine Einspeisung von Strom in ein elektrisches Netz oder an einen Abnehmer NET statt. Die Gegenleistung für diesen die Batterie BAT entladenden Übertragungsvorgang schwankt mit der Zeit; Kosten für elektrische Energie liegen bei Industriestrom bei ca. 2-3 Cent/KWh, die Handelspreise für Strom hingegen können zwischen 15 und 80 Cent/KWh und sogar noch höher liegen. Entsprechendes gilt auch für die Batterie BAT aufladende Übertragungsvorgänge. Daher sind manche Übertragungsvorgänge für den Betreiber der Batterie BAT aus wirtschaftlicher Sicht sinnvoll, andere nicht.

Bei einem solchen kommerziellen Einsatz einer Batterie ist es vorteilhaft, die Auswirkungen der Benutzung der Batterie BAT auf Grund von nutzungsbedingter Alterung möglichst exakt zu ermitteln und mit den Gegenleistungen für Übertragungsvorgänge zu korrelieren. Soll beispielsweise eine Batterie am Stromnetz betrieben werden und am Stromhandelsmarkt teilnehmen, ist der Gewinn eines Übertragungsvorgangs, d.h. die Differenz zwischen einerseits den Kosten für die Erzeugung oder den Einkauf von durch die Batterie zu speichernder Energie und andererseits der Einnahme durch das spätere Zur-Verfügung-Stellen von gespeicherter Energie, auch von der hierdurch hervorgerufenen Alterung oder Abnutzung der Batterie abhängig, im Folgenden als Schädigungswert bezeichnet.

Dieser Schädigungswert wird jedoch nicht durch einfache wirtschaftliche Betrachtungen ermittelt, wie z.B.: ist eine Batterie 1000mal benutzbar und hat 1000€ bei der Beschaffung gekostet, dann ist ein Benutzungszyklus mit 1€ in der Kalkulation zu berücksichtigen. Vielmehr werden die Eigenschaften und das Verhalten der Batterie analysiert, um hieraus den Schädigungswert abzuleiten:
Eine besonders zu berücksichtigende Eigenschaft von Batterien ist, dass kleine Lade-/Entladevorgänge überproportional weniger Alterung erzeugen als große Zyklen. Die Lade-/Entladetiefe bzw. der Hub wird als DoD (Abkürzung von "Depth of Discharge") bezeichnet. In einem vereinfachten Beispiel würde eine Ladung und Entladung mit einem DoD von 50%, also entsprechend der Hälfte der Kapazität, deutlich weniger als 50% der Alterung eines 100%-Zyklus erzeugen. Z.B. ist die Alterung eines 50%-Zyklus ca. 30%-40% so groß wie die eines 100%-Zyklus.

Dieses Verhalten ähnelt in weiten Teilen der Materialermüdung durch mechanischen Stress, z.B. beim Biegen von Metallteilen. Ein Metallteil kann üblicherweise sehr oft um wenige Winkelgrad gebogen werden, wird aber bei einer 180°-Biegung sehr schnell brechen. Dieses Verhalten wird in der materialwissenschaftlichen Literatur durch "Wöhler-Kurven" repräsentiert. In Anlehnung daran kann die Alterung einer Batterie, bezogen auf ihre Entladetiefe DoD, durch Wöhler-Kurven ähnliche Kurven bzw. Kurvenscharen dargestellt werden. Diese Kurven werden im Folgenden als Schadensgewichtungskurven bezeichnet.

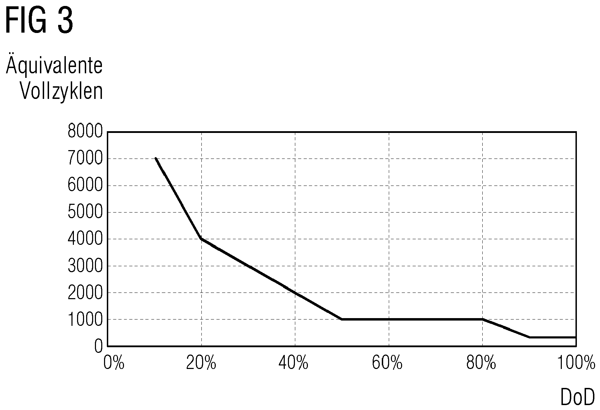

Figur 3 zeigt ein Beispiel für eine solche Schadensgewichtungskurve. Diese zeigt, wie viele äquivalente Vollzyklen bei den jeweiligen Entladetiefen (DoD) möglich sind, bevor die Batterie ihr Lebensdauerende erreicht. Unter dem Erreichen des Lebensdauerendes wird hierbei ein bestimmter Grenzwert des Gesundheitszustandes der Batterie verstanden, z.B. 80%. Ein "Äquivalenter Vollzyklus" bezeichnet die summierte Anzahl kleiner Zyklen, die den gleichen Energieumsatz wie ein 100% Zyklus haben. 10 Zyklen mit einem DoD von 10% entsprechen z.B. einem äquivalenten Vollzyklus, und 2 Zyklen mit einem DoD von 50% entsprechen einem äquivalenten Vollzyklus. Es ist zu erkennen, dass die maximal mögliche Anzahl an äquivalenten Vollzyklen mit der Entladetiefe DoD abnimmt. D.h. die Batterie erreicht ihr Lebensdauerende nach deutlich weniger äquivalenten Vollzyklen, wenn sie häufig mit großen Entladungstiefen DoD arbeiten muss.

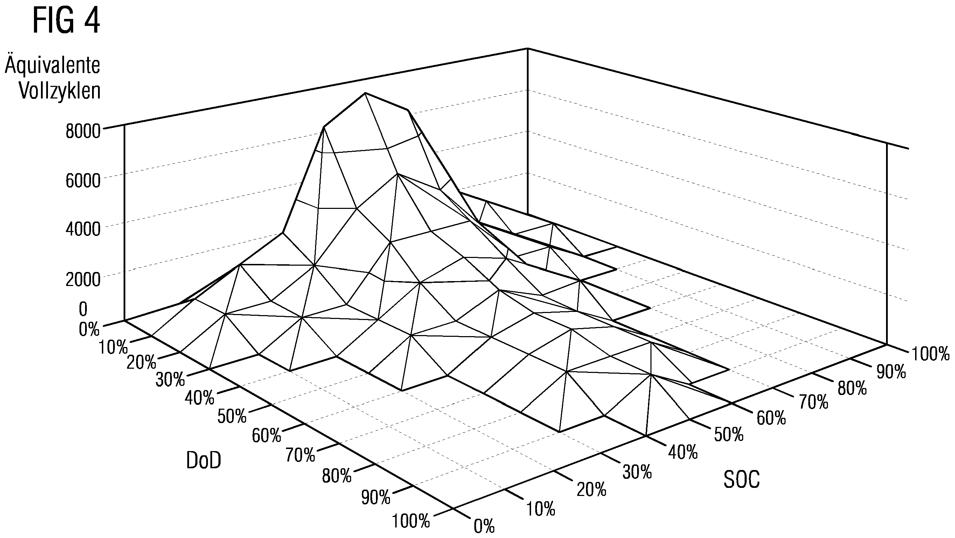

Während Figur 3 eine zweidimensionale Schadensgewichtungskurve zeigt, wird das reale Verhalten der Batterie vollständig durch eine Schar von Schadensgewichtungskurven beschrieben. Eine solche Schar von Schadensgewichtungskurven ist in Figur 4 zu sehen. Auf der X-Achse (unten links) ist die Entladetiefe DoD abgebildet, auf der Y-Achse (unten rechts) der Ladezustand SOC, die Z-Achse gibt die in dem jeweiligen Zustand maximal möglichen äquivalenten Vollzyklen an.

Der Ladezustand SOC entspricht hierbei dem Mittelwert innerhalb des Zyklus: z.B. bedeutet ein Ladezustand SOC von 50% und eine Entladetiefe DoD von 50%, dass die Batterie ausgehend vom Ladezustand 75% auf den Ladezustand 25% entladen und anschließend wieder auf 75% aufgeladen wird, oder umgekehrt; z.B. bedeutet ein Ladezustand SOC von 30% und eine Entladetiefe DoD von 60%, dass die Batterie ausgehend vom Ladezustand 60% auf den Ladezustand 0% entladen und anschließend wieder auf 60% aufgeladen wird, oder umgekehrt. Dementsprechend sind einige Kombinationen von DoD und SOC nicht möglich, was an der Anzahl 0 von möglichen äquivalenten Vollzyklen ablesbar ist. Wie auch bei der Schadensgewichtungskurve der Figur 3 ist in Figur 4 zu sehen, dass die bis zum Erreichen des Lebensdauerendes der Batterie maximal mögliche Anzahl äquivalenter Vollzyklen mit der Entladetiefe DoD stark abnimmt.

Während Figur 4 eine dreidimensionale Kurvenschar zeigt, ist es auch möglich, weitere Dimensionen zu berücksichtigen. Hierdurch können weitere Umgebungsparameter als Dimension, die das Schädigungsausmaß bestimmt, einbezogen werden, z.B. die Temperatur, wobei hohe Temperaturen das Altern einer Batterie fördern, die mechanische Presskraft, die Pause zwischen Ladepulsen, sowie die Höhe des Stroms, entsprechend der Zeit, in der eine bestimmte Ladungsmenge umgesetzt wird.

Dem weiteren Vorgehen liegt die Kenntnis einer Schar von Schadensgewichtungskurven für die verwendete Batterie zugrunde. Von besonderem Vorteil ist, es, wenn diese Kurvenschar mittels des neuartigen "High Precision Cycling" (im Folgenden: HPC) ermittelt wird.

Grundlagen des HPC Verfahrens sind beschrieben z.B. in
Dahn et al.: "Importance of Coulombic Efficiency Measurements in R&D Efforts to Obtain Long-Lived Li-Ion Batteries", The Electrochemical Society Interface, Fall 2016, www.electrochem.org
Smith et al.: "Interpreting High Precision Coulometry Results on Li-ion Cells", Journal of The Electrochemical Society, 158 (10) A1136-A1142 (2011)

Auf diesen grundlegenden Arbeiten, welche die Ermittlung der Coulomb Effizienz von Batterien betrifft, aufbauend wird die HPC nun verwendet, um die Alterungsgeschwindigkeit einer Batterie zu bestimmen. Dies ist ausführlich beschrieben in der europäischen Patentanmeldung mit dem Anmeldeaktenzeichen 21164160.0.

Dieses Verfahren wird hier nur verkürzt beschrieben:

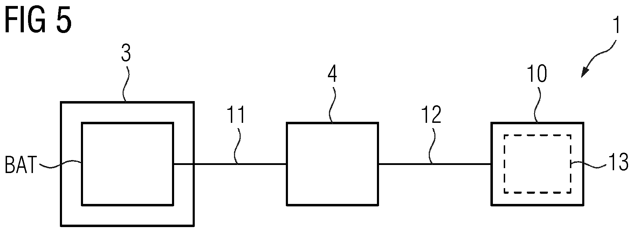

In Figur 5 ist eine Vorrichtung 1 zum Bestimmen von Schadensgewichtungskurven mittels der Hoch-Präzisions-Coulometrie gezeigt. Die Batterie BAT ist in einer Temperierkammer 3 angeordnet. Sie ist über ein Stromkabel 11 mit einer Hoch-Präzisions-Coulometrie-Vorrichtung 4 verbunden. Die Hochpräzisions-Coulometrie-Vorrichtung 4 ist wiederum mit einer Recheneinheit 10 über ein Datenkabel 12 verbunden. Die Hochpräzisions-Coulometrie-Vorrichtung 4 nimmt mit sehr großer Genauigkeit ein Ladungs-Zeit-Diagramm der Batterie BAT auf. Hierzu wird die Batterie BAT mit einem periodischen Lastzyklus betrieben.

Von der Hochpräzisions-Coulometrie-Vorrichtung 4 wird ein Spannungs-Zeit-Diagramm während eines periodischen Lastzyklus der Batterie aufgezeichnet, d.h. ein bestimmter Lastzyklus wird wiederholt auf die Batterie BAT angewendet. Dieser Lastzyklus wird bei einem bestimmten Arbeitspunkt der zu ermittelnden Kurvenschar angewendet, also bei einer bestimmten Kombination von DoD und SOC. Sollten die Kurvenscharen in weitere Dimensionen vorliegen, werden diese auch Einflussgrößen bei der HPC ebenfalls angewandt. Basierend auf dieser Messung wird ermittelt, welche kumulative Ladungsmenge in den einzelnen Lade- und Entlade-Schritten geflossen ist. Aus den Ladungsverschiebungen wird nun der mittlere Kapazitätsverlust der Batterie für den betrachteten Lastzyklus ermittelt. Basierend auf dem mittleren Kapazitätsverlust ist es nun möglich, eine Restkapazität der Batterie zu bestimmen und somit für den konkreten Lastzyklus eine Vorhersage für das Alterungsverhalten der untersuchten Batterie bei den Bedingungen des Lastzyklus zu treffen. Aus diesem Alterungsverhalten kann die maximal mögliche Anzahl äquivalenter Vollzyklen bis zum Erreichen des Lebensdauerendes der Batterie abgeleitet werden. Dies liegt darin begründet, dass das Ende der Batterie-Lebensdauer üblicherweise durch Erreichen einer bestimmten Restkapazität definiert wird. Das beschriebene Vorgehen entspricht der Ermittlung eines Stützwertes, also eines Punktes auf der Oberfläche der Schadensgewichtungskurvenschar. Die beschriebene Ermittlung wird von einem Computerprogramm 13 unterstützt oder durchgeführt.

Dieses Verfahren bietet den Vorteil, die vollständige Schadensgewichtungskurvenschar mit einer großen Zahl von Stützwerten innerhalb weniger Wochen bis Monate zu geringen Kosten ermitteln zu können. Mit herkömmlichen Verfahren hingegen müsste der Alterungsprozess der Batterie über einen Zeitraum von Jahren beobachtet werden, um das gleiche Resultat zu erhalten.

Das im Folgenden weiter beschriebene Verfahren kann basierend auf der mittels der HPC ermittelten Schadensgewichtungskurvenschar durchgeführt werden. Es ist also nur eine einmalige Vermessung der Batterie nötig. Jedoch ist es möglich, dass das Verhalten der Batterie sich mit zunehmendem Alter verändert, d.h. von der aufgrund der ursprünglichen HPC Messung getroffenen Prognose abweicht. Es können sich also im Laufe der Alterung der Batterie die Alterungsraten ändern, d.h. von dem Ergebnis der ursprünglichen Messung abweichen. Daher ist es sinnvoll, die HPC Messung von Zeit zu Zeit zu wiederholen.

Hierzu kann die in Figur 5 gezeigte Anordnung mit der Batterie zusammen installiert werden. Gegebenenfalls kann hierbei auf die Temperierkammer 3 verzichtet werden. Bei der Nachmessung kann zunächst stichpunktartig vorgegangen werden: es werden nur für vereinzelte Kombinationen von DoD und SOC Stützpunkte ermittelt. Wenn diese mit der ursprünglichen Messung übereinstimmen, ist keine Anpassung und somit auch nicht die Messung und Auswertung von Werten für weitere Stützpunkte nötig. Bei einer gleichmäßigen Verschiebung der Nachmessungen gegenüber den ursprünglichen Werten kann die gesamte Kurvenschar verschoben werden. Auf diese Weise dauert das Nachmessen nur wenige Tage. Wenn hingegen die Ergebnisse der Nachmessungen deutlich und/oder in unregelmäßiger Weise von den ursprünglichen Werten abweichen, sollten mehrere Arbeitspunkte vermessen werden.

Da während der Nachmessungen die Batterie offline sein muss, d.h. nicht für die Auflad- und Entladvorgänge verwendet werden kann, für welche sie üblicherweise eingesetzt wird, sollte hierfür ein geeigneter Zeitpunkt gefunden werden. Z.B. ist dies im Rahmen von Wartungsarbeiten der Fall, während welcher die Batterie ohnehin nicht arbeiten kann.

Die HPC bietet also insbesondere die Möglichkeit, mit deutlich weniger Messkanälen auszukommen, wobei ein Messkanal einem Prüfstand entspricht, bei welchem sich die zu prüfende Batterie an einem Messgerät befindet. Denn an einem Alterungspunkt können durch die HPC die momentanen Alterungsraten für alle interessanten Betriebsparameter ermittelt werden. Denn durch die kurze Messzeit erfolgt keine nennenswerte Veränderung des Alterungszustandes im Laufe der Messung. Die Messung bezieht sich also ein bestimmtes Alter der Batterie.

Bei einer Nachmessung können an einem neuen Alterungspunkt wieder alle Alterungsraten für alle interessierenden Betriebsparameter gemessen werden. Das ist ein Vorteil gegenüber herkömmlichen Verfahren, bei welchen vollfaktorielle Messungen der Lebensdauern mit vielen Prüflingen ermittelt werden müssen. Dies ist sowohl zeit- als auch ressourcenaufwendig hinsichtlich der zu prüfenden Batterien und den Laborkapazitäten, und kostet überdies oft mehr Geld als in einem sinnvollen Verhältnis zu den Preisen für Batterien stehen könnte.

Wie einleitend erläutert, soll der Schädigungswert für einen bestimmten Nutzungsvorgang der Batterie bestimmt werden. Dies erfolgt durch eine Umrechnung der Werte der Schadensgewichtungskurvenschar in den gesuchten Schädigungswert. Dies wird anhand eines konkreten Beispiels illustriert:
Die Batterie habe einen Gesamtpreis, umfassend Anschaffung und lebenslange Betriebskosten, von 1.000.000 €. Es wird ein Zyklus mit einem DoD von 20% bei einem SoC von 50% betrachtet. Für diesen seien gemäß der Schadensgewichtungskurvenschar 5000 äquivalente Vollzyklen erlaubt. Der betrachtete 20%-Hub erzeugt daher einen Alterungsschaden von 20% von 1/5000 der Gesamtlebensdauer, also 40ppm. Mit den genannten Systemkosten würde dieser Zyklus also 40€ Alterungskosten verursachen.

Diese Ermittlung der Schädigungswerte bildet das reelle Verhalten der Batterie ab, da sie auf der Schadensgewichtungskurvenschar basiert, wodurch jedem beliebigen Zyklus der tatsächliche Schaden beigemessen wird. Dem gegenüber wird derzeit gemäß der industrieübergreifend am weitest verbreiteten Lösung grundsätzlich der Worst-Case angenommen und auf dieser Basis gearbeitet. Hierdurch wird zwangsläufig ein signifikantes Potenzial der Batterie ungenutzt bleiben. Am konkreten Beispiel bedeutet dies: auf Basis einer typischen erwarteten Nutzung der Batterie wird eine maximale Anzahl von Vollzyklen frei gegeben, also z.B. einen Vollzyklus pro Tag für 10 Jahre, d.h. 3650 Vollzyklen insgesamt. Teilzyklen werden linear anteilig gerechnet. Zwei halbe Zyklen werden also gewertet wie ein Vollzyklus. Wie anhand der Schadensgewichtungskurven ersichtlich, wären bei reduziertem DoD eigentlich deutlich mehr Zyklen möglich, die Batterie wird in diesem Fall also nicht im Optimum betrieben, da sie mehr Zyklen fahren könnte als tatsächlich umgesetzt werden. Dies führt bislang zu einem verfrühten Austausch der Batterie, was eine erhebliche Ressourcenverschwendung darstellt. Bekannterweise werden für die Batterieherstellung wertvolle und knappe Ressourcen benötigt und das Recycling "verbrauchter" Batterien ist aufwendig.

Bislang wurde die Eigenschaft von Batterien betrachtet, dass sich Zyklen mit großen Hüben und auch Zyklen bei niedrigem oder hohem SoC überproportional negativ auf die Lebenserwartung der Batterie auswirken. Außer dieser bereits betrachteten Eigenschaft soll ferner noch folgendes berücksichtigt werden:
Erschwerend kommt hinzu, dass die Zyklustiefe DoD seine Alterungswirkung auch bei unterbrochenen Zyklen zeigt. Z.B. erzeugt eine Entladung um 40%, bestehend aus zwei Entladungen zu je 22%, unterbrochen um einen Ladepuls von 4%, näherungsweise die gleiche Alterung wie eine ununterbrochene 40%-Entladung. Berücksichtigt man, dass durch zurückliegende Auf- oder Entladevorgänge der jeweils betrachtete Vorgang in seiner Kritikalität hinsichtlich der Alterung beeinflusst wird, ist es noch aufwendiger, für jeden Benutzungszyklus den korrekten Schädigungswert zu ermitteln.

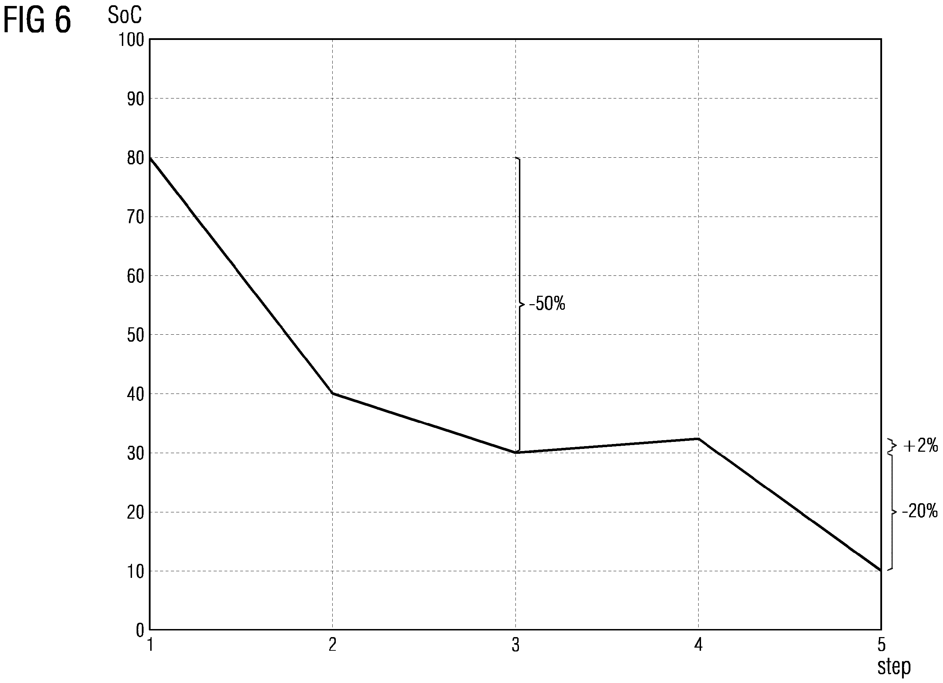

Dieser Effekt wird anhand des in Figur 6 gezeigten Verlaufs der Entladung einer Batterie illustriert. Der Ladezustand SoC liegt anfänglich bei 80%, entsprechend dem Zeitpunkt step 1. Es erfolgt eine Entladung um 40% (Zeitpunkt step 2), gefolgt von einer weiteren Entladung um 10% (Zeitpunkt step 3). Zwischen den Zeitpunkten step 3 und step 4 findet ein kurzes Laden der Batterie um 2% statt. Im Anschluss wird die Batterie um weitere 20% entladen (Zeitpunkt step 5). Der Schädigungswert dieses Verlaufs hinsichtlich der Entladung entspricht einer Entladung um 70% bei einem mittleren SoC von 45%. Dieser ist höher als die Summe der beiden Schädigungswerte des Entladens um 50% und des Entladens um 20%. Dies bedeutet, dass hinsichtlich der Schädigung der Batterie die beiden Entladungsabschnitte von 50% und 20% zu einem Makro-Halbzyklus zusammengefasst werden müssen, obwohl diese durch den Mikro-Halbzyklus der Entladung um 2% unterbrochen sind.

Um dieses Batterieverhalten zu berücksichtigen, wird die oben erläuterte Ermittlung der Schädigungswerte um eine Sensitivität gegenüber zurückliegenden (Halb)Zyklen ergänzt. Hierdurch können die überproportional größeren Schadwirkungen von Makrozyklen berücksichtigt werden. So ist es zum Beispiel relevant, wenn ein anstehender 30%-Ladevorgang im Kontext eines zurückliegenden 50%-Ladevorganges gesehen werden muss, da er in diesem Fall die Alterungswirkung eines 80%-Pulses hat.

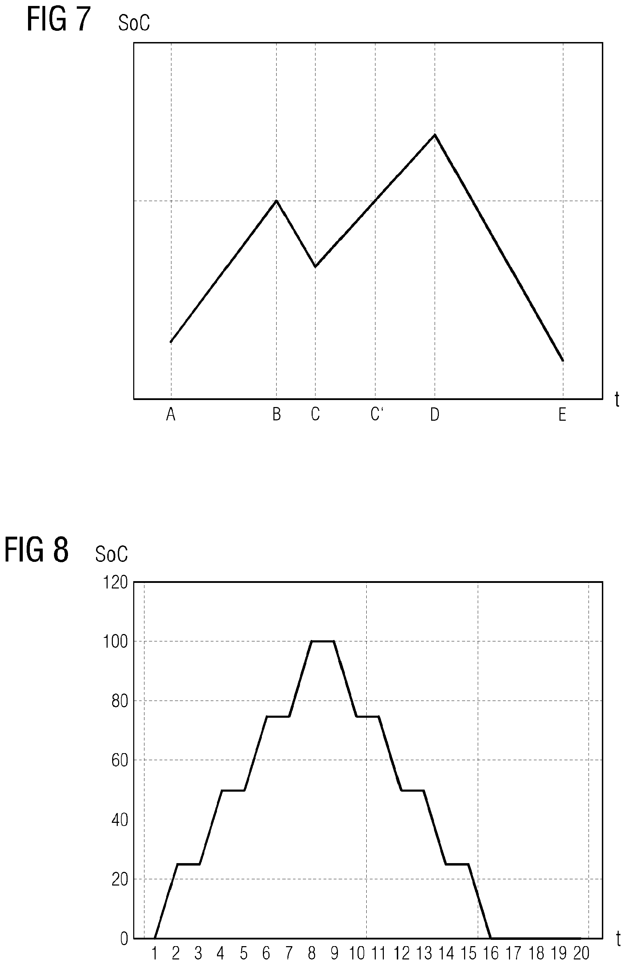

Hierzu wird der zeitliche Verlauf des Ladezustands der Batterie kontinuierlich von einem Algorithmus zum Auswerten von Zyklen analysiert. Hierzu eignet sich besonders der Rainflow Algorithmus. Dieser zerlegt einen an sich beliebigen Verlauf einer Kurve in Makro- und Mikro Zyklen oder Halbzyklen. Dies wird anhand der beiden Beispiele der Figuren 7 und 8 erläutert.

Figur 7 zeigt einen ersten Verlauf des Ladungszustands SoC einer Batterie, aufgetragen über die Zeit t. Es erfolgt ein Aufladen zwischen den Zeitpunkten A und B, sowie C und D, und ein Entladen zwischen den Zeitpunkten B und C, sowie D und E. Durch den Rainflow Algorithmus wird der Abschnitt zwischen A und B, zusammen mit dem Abschnitt zwischen C' und D zu einem ersten Halbzyklus zusammengefasst. Der hierzu gehörige zweite Halbzyklus ist der Abschnitt zwischen D und E. Ein weiterer Halbzyklus ist derjenige zwischen B und C, zu welchem der Halbzyklus zwischen C und C' gehört.

Figur 8 zeigt einen zweiten Verlauf des Ladungszustands SoC einer Batterie, aufgetragen über die Zeit t. Es erfolgt ein Aufladen der Batterie zwischen den Zeitpunkten 1 und 2, 3 und 4, 5 und 6, sowie 7 und 8; das Entladen findet zwischen den Zeitpunkten 9 und 10, 11 und 12, 13 und 14, sowie 15 und 16 statt. Durch den Rainflow Algorithmus werden alle Zeitabschnitte der Aufladung zu einem ersten Halbzyklus zusammengefasst, und alle Zeitabschnitte des Entladens zum dazugehörigen zweiten Halbzyklus.

Der Rainflow Algorithmus läuft hierbei kontinuierlich mit. Dies bedeutet, dass es Halbzyklen gibt, welche der Algorithmus als abgeschlossen einordnet, und solche, welche noch offen sind. Sobald ein Halbzyklus oder Vollzyklus durch den Algorithmus als abgeschlossen eingeordnet wird, kann diesem abschließend ein Schädigungswert zugeordnet werden. Dies erfolgt, indem der zu dieser Kombination von DoD und SoC des Halbzyklus gehörende Wert in der Schadensgewichtungskurvenschar ermittelt wird. Es werden also die Lade/Entladevorgänge im Kontext der Belastungshistorie bewertet.

Da der Algorithmus fortwährend mitläuft, finden für die noch nicht abgeschlossenen Zyklen oder Halbzyklen Neubewertungen statt. Im Beispiel der Figur 8 bedeutet dies, dass das erste Aufladen zwischen den Zeitpunkten 2 und 3 zunächst als 25% Hub angesehen wird. Wenn das zweite Aufladen zwischen den Zeitpunkten 4 und 5 erfolgt, werden die beiden 25% Aufladungen zu einem 50% Hub zusammengefasst. Ebenso erfolgt später ein Zusammenfassen der folgenden Aufladevorgänge zu einem gesamten 75% bzw. 100% Hub.

Die wie beschrieben ermittelten Schädigungswerte können nun bei Entscheidungen über das Betreiben der Batterie einbezogen werden. Hierbei können an sich verschiedene Zielsetzungen verfolgt werden:
- Die Batterie soll so betrieben werden, dass eine möglichst lange Zeit bis zum Erreichen des Lebensdauerendes verstreicht. Hierbei sollte berücksichtigt werden, welche Zyklen gemäß der verwendeten Schadensgewichtungskurven und Schädigungswerte eine rasche Reduktion des SOH zur Folge haben.
- Die Batterie soll so betrieben werden, dass bis zum Erreichen des Lebensdauerendes viel Durchsatz, d.h. Auf- und Entladevorgänge, ermöglicht wird. Dies berücksichtigt die kalendarische Alterung der Batterie. Denn wenn eine Batterie während des erlaubten Kalenderlebens, entsprechend einer bestimmten Anzahl von Jahren wie z.B. 15 Jahre, nur wenig zyklisiert wurde, ist sie danach trotzdem am unteren Limit ihres SOH. Man kann Auf- und Entladezyklen dann nicht mehr nachholen, da z.B. das Elektrolyt alterungsbedingt ausgetrocknet ist. Es ist daher wichtig, die theoretisch möglichen Zyklen auch in der richtigen Zeit zu verbrauchen.
- Die Batterie soll so betrieben werden, dass Schädigungswert und erzielbare Gegenleistung für einen Auf- oder Entladevorgang in einem gewünschten Verhältnis zueinanderstehen.

Die Erfindung wurde voranstehend an einem Ausführungsbeispiel beschrieben. Es versteht sich, dass zahlreiche Änderungen und Modifikationen möglich sind, ohne dass der Rahmen der Erfindung verlassen wird.

## Patentansprüche

1. Verfahren zur Beurteilung einer Batteriealterung,
bei welchem zunächst
Anzahlen (Äquivalente Vollzyklen) möglicher Auf- oder Entladevorgänge einer Batterie (BAT) in Abhängigkeit von der Tiefe (DoD) des jeweiligen Vorgangs ermittelt werden,
und dann
beim Betreiben der Batterie (BAT) ein zukünftiger Auf- oder Entladevorgang einem Vorgang einer bestimmten Tiefe (DoD) zugeordnet wird unter Berücksichtigung von einem oder mehreren zuvor erfolgten Auf- oder Entladevorgängen,
und schließlich
ein durch den zukünftigen Auf- oder Entladevorgang hervorgerufener Schädigungswert bestimmt wird unter Verwendung der ermittelten Anzahlen (Äquivalente Vollzyklen) möglicher Auf- oder Entladevorgänge.

2. Verfahren nach Anspruch 1, bei dem
die Ermittlung der Anzahlen (Äquivalente Vollzyklen) möglicher Auf- oder Entladevorgänge mittels einer Hoch-Präzisions-Coulometrie-Messung erfolgt.

3. Verfahren nach Anspruch 2, bei dem
basierend auf der Hoch-Präzisions-Coulometrie-Messung ein Kapazitätsverlust pro Auf- oder Entladevorgang einer bestimmten Tiefe (DoD) ermittelt wird.

4. Verfahren nach einem der Ansprüche 1 bis 3, bei dem nach einem zeitweiligen Betreiben der Batterie (BAT) erneut die Ermittlung der Anzahlen (Äquivalente Vollzyklen) möglicher Auf- oder Entladevorgänge erfolgt.

5. Verfahren nach einem der Ansprüche 1 bis 4, bei dem die Anzahlen (Äquivalente Vollzyklen) möglicher Auf- oder Entladevorgänge zusätzlich abhängen von dem mittleren Ladezustand (SOC) der Batterie (BAT) während des jeweiligen Vorgangs.

6. Verfahren nach einem der Ansprüche 1 bis 5, bei dem die Zuordnung eines bestimmten Auf- oder Entladevorgangs zu einem Vorgang einer bestimmten Tiefe (DoD) wiederholt durchgeführt wird, und aufgrund von mindestens einem weiteren zwischenzeitlich erfolgten Auf- oder Entladevorgang eine neue Zuordnung erfolgt.

7. Verfahren nach einem der Ansprüche 1 bis 6, bei dem die Zuordnung unter Verwendung eines Rainflow Algorithmus erfolgt.

8. Verfahren nach einem der Ansprüche 1 bis 7, bei dem der Schädigungswert bei einer Entscheidung über die Durchführung eines bestimmten Auf- oder Entladevorgangs verwendet wird.

9. Vorrichtung oder System zur Datenverarbeitung, umfassend Mittel zur Bestimmung von Zuordnungen und Schädigungswerten innerhalb eines Verfahrens nach einem der Ansprüche 1 bis 8.

10. Computerprogramm, umfassend Befehle, die bei der Ausführung des Programms durch einen Computer diesen veranlassen, Zuordnungen und Bestimmungen von Schädigungswerten nach einem der Ansprüche 1 bis 8 durchzuführen.

11. Computerlesbarer Datenträger, auf dem das Computerprogramm nach Anspruch 10 gespeichert ist.

12. Datenträgersignal, das das Computerprogramm nach Anspruch 10 überträgt.
